(19) Europäisches Patentamt
European Patent Office
Office européen des brevets

(11) **EP 2 598 669 B1**

(12) **FASCICULE DE BREVET EUROPEEN**

(45) Date de publication et mention
de la délivrance du brevet:
**23.11.2022 Bulletin 2022/47**

(51) Classification Internationale des Brevets (IPC):
**C23C 16/27** (2006.01)    **C23C 16/52** (2006.01)
**C23C 16/30** (2006.01)

(21) Numéro de dépôt: **11738724.1**

(22) Date de dépôt: **01.08.2011**

(52) Classification Coopérative des Brevets (CPC):
**C23C 16/27; C23C 16/278; C23C 16/30;
C23C 16/52**

(86) Numéro de dépôt international:
**PCT/EP2011/063255**

(87) Numéro de publication internationale:
**WO 2012/013824 (02.02.2012 Gazette 2012/05)**

(54) **PROCEDE POUR SYNTHETISER PAR DEPOT CHIMIQUE EN PHASE VAPEUR UNE MATIERE, EN PARTICULIER DU DIAMANT, AINSI QU'UN DISPOSITIF POUR L'APPLICATION DU PROCEDE**

VERFAHREN ZUR SYNTHESE EINES MATERIALS, IM BESONDEREN VON DIAMANTEN MITTELS GASPHASENABSCHEIDUNG SOWIE VORRICHTUNG ZUR ANWENDUNG DES VERFAHRENS

METHOD FOR SYNTHESIZING A MATERIAL, IN PARTICULAR DIAMONDS, BY CHEMICAL VAPOR DEPOSITION, AS WELL AS DEVICE FOR APPLYING THE METHOD

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **30.07.2010  BE 201000472**

(43) Date de publication de la demande:
**05.06.2013  Bulletin 2013/23**

(60) Demande divisionnaire:
**18155872.7 / 3 366 806**

(73) Titulaire: **Diarotech
6060 Gilly (BE)**

(72) Inventeur: **TELLEZ OLIVA, Horacio
B-6060 Gilly (BE)**

(74) Mandataire: **Office Kirkpatrick et al
Avenue Wolfers, 32
1310 La Hulpe (BE)**

(56) Documents cités:
**WO-A2-2009/005862    US-A- 4 898 748**

**US-A- 5 478 608**

• **JIE MA ET AL: "Laser-aided diagnosis of the gas phase chemistry in microwave activated plasmas used for depositing diamond thin films", PROCEEDINGS OF THE 13TH INTERNATIONAL SYMPOSIUM ON LASER-AIDED PLASMA DIAGNOSTICS : 18 - 21 SEPTEMBER, 2007, HIDA HOTEL PLAZA, TAKAYAMA, JAPAN (IN: NIFS-PROC),, vol. 68, 18 septembre 2007 (2007-09-18), pages 206-211, XP009146265,**
• **POPOV C ET AL: "Chemical bonding study of nanocrystalline diamond films prepared by plasma techniques", THIN SOLID FILMS, ELSEVIER-SEQUOIA S.A. LAUSANNE, CH, vol. 506-507, 26 mai 2006 (2006-05-26), pages 297-302, XP025005711, ISSN: 0040-6090, DOI: DOI:10.1016/J.TSF.2005.08.109 [extrait le 2006-05-26]**
• **LEE CHING-TING ET AL: "Crystalline SiGe films grown on Si substrates using laser-assisted plasma-enhanced chemical vapor deposition at low temperature", APPLIED PHYSICS LETTERS, AIP, AMERICAN INSTITUTE OF PHYSICS, MELVILLE, NY, US, vol. 91, no. 9, 30 août 2007 (2007-08-30), pages 91920-91920, XP012100867, ISSN: 0003-6951, DOI: DOI:10.1063/1.2779103**

**Description**

La présente invention concerne un procédé pour synthétiser par dépôt chimique en phase vapeur (CVD) une matière, en particulier du diamant, suivant lequel on crée dans une chambre sous vide un plasma au voisinage d'un substrat agencé à porter la matière à synthétiser, et suivant lequel on introduit dans la chambre une substance porteuse de carbone, en particulier du CH4 ou du C2 H2 , et du H2 afin de produire dans la chambre un gaz comprenant des substances porteuses d'atomes de carbone réactif sous forme de radicaux ou de molécules insaturées à partir desquels la synthèse de ladite matière sera réalisée.

Un tel procédé est connu du brevet US 4 859 490. Suivant le procédé connu on utilise une chambre sous vide, qui est maintenue à une pression entre 40 et 400 Torr et dans laquelle se trouve le substrat. Le plasma est créé à l'aide d'un potentiel électrique appliqué entre un filament et une grille, laquelle grille est située entre le filament et le substrat. Le filament est chauffé à une température d'au moins 1600° C et un gaz, porteur de carbone, ainsi que du H2 sont introduits dans la chambre pour permettre de synthétiser par dépôt chimique en phase vapeur du diamant à partir du carbone. L'utilisation de plasma et l'appareillage associé pour la synthèse de diamant sont également divulgués dans US4898748A, US5478608, Jie Ma et al, Proceedings of the 13th International Symposium on Laser-aided Plasma Diagnostics : 18-21 September 2007, vol. 68, 18, september 2007, page 206-211, and Popov C et al, Thin Solid Films, Elsevier-Sequoia S.A. Lausanne, CH, vol. 506-507, 26 may 2006, pages 297-302.

Un désavantage du procédé connu est que la vitesse de dépôt de la matière solide à synthétiser est faible, de l'ordre de 1 pm par heure, ce qui fait que la procédure, même si elle procure un diamant de synthèse de bonne qualité, n'est d'un point de vue économique que peu rentable.

L'invention a pour but de réaliser un procédé pour synthétiser du diamant par dépôt chimique en phase vapeur selon la revendication 1, lequel procédé permet d'obtenir une vitesse de dépôt plus élevée que celle du procédé connu tout en ayant une bonne qualité de la matière.

A cette fin un procédé suivant l'invention est caractérisé en ce que les spectres électromagnétiques d'absorption et de diffusion inélastique du diamant à synthétiser sont utilisés pour prélever dans ces spectres les fréquences d'absorption qui contribuent aux réactions qui mènent à la formation de la matière à synthétiser, et en ce que l'on produit des rayons énergétiques sous forme d'un faisceau de photons porteur de quantités d'énergie déterminées par chacune des fréquences correspondant auxdites fréquences d'absorption et de diffusion inélastique, lequel faisceau de photons est injecté dans le plasma où pour des états énergétiques du diamant une absorption de ces photons ayant l'énergie correspondant à ces états énergétiques est réalisée par les substances porteuses desdits atomes de carbone réactif. En produisant et en injectant des rayons énergétiques sous forme d'un faisceau de photons porteur d'énergie, qui chaque fois correspond précisément aux fréquences d'absorption (intrinsèques ou activés par défaut) et de diffusion inélastique (de photons et de neutrons), les substances porteuses desdits atomes de carbone réactif présents dans le plasma créé dans la chambre peuvent absorber une énergie qui correspond adéquatement à celle des états énergétiques du diamant à synthétiser. Ceci permet donc de mieux cibler l'énergie à absorber pour synthétiser le diamant que l'on souhaite obtenir. Ainsi, la probabilité de former des molécules de diamant est sensiblement augmentée, ce qui permet une vitesse de dépôt de diamant nettement plus élevée que celle du procédé connu. De plus en ciblant l'énergie à absorber la qualité du diamant est excellente.

De préférence l'on introduit un gaz porteur de carbone en tant que ladite substance. L'apport d'un gaz est facile à contrôler et permet une absorption plus efficace des rayons énergétiques.

De préférence, des rayons Infra Rouge sont utilisés en tant que rayons énergétiques pour réaliser un couplage entre les états énergétiques des radicaux ou des molécules insaturées et les états énergétiques des phonons de la matière. Ces rayons Infra Rouge couvrent une large gamme des fréquences présentes dans le spectre de la matière à synthétiser. Une première forme de réalisation préférentielle d'un procédé suivant l'invention est caractérisée en ce que la matière à synthétiser comporte une maille cristallographique qui détermine un ensemble de faciès, par exemple l'octaèdre, ou le dodécaèdre dans le cas du diamant, représentée par deux jeux de vecteurs directionnels, le premier indiquant les directions normales aux principaux plans réticulaires, de plus haute densité atomique déterminant les faciès possibles de ladite matière, le second étant constitué des vecteurs d'ondes permis pour la propagation des phonons en fonction de la structure cristallographique de la matière, ledit faisceau de photons étant orienté et injecté suivant des directions indiquées par lesdits deux jeux de vecteurs directionnels. Dans cette forme de réalisation le procédé consiste alors à injecter des faisceaux de photons possédant les énergies des modes de phonon $\omega$ qui sont orientés selon les vecteurs d'onde K correspondants, inscrits dans la zone de Brillouin, que l'on prélève sur les courbes de dispersion de ladite matière, par exemple aux points critiques et aux points de haute symétrie, en ce compris le centre de la zone noté couramment par $\Gamma$. Ces deux jeux de directions relatifs aux mailles respectives du réseau direct et du réseau réciproque, fournissent en définitive les directions choisies pour ledit faisceau de photons. En tenant compte de ces deux jeux de vecteurs lors de l'injection du faisceau de photons on parvient à augmenter la probabilité d'interaction entre les photons et les phonons et on contribue ainsi à augmenter la vitesse de dépôt de la matière à synthétiser.

Une deuxième forme de réalisation préférentielle d'un procédé suivant l'invention est caractérisée en ce qu'un faisceau de rayons UV-c est injecté dans le plasma. L'injection d'un faisceau d'UV-c permet en particulier d'augmenter la densité du plasma et ainsi stimuler la synthèse de diamant solide.

Une troisième forme de réalisation préférentielle d'un procédé suivant l'invention est caractérisée en ce que le plasma est produit par la création d'un champ électrique dans la chambre sous vide, ledit champ électrique étant créé à l'aide d'un premier et d'un deuxième potentiel électrique, ledit premier potentiel électrique est créé dans une première zone décalée dans le sens de la hauteur par rapport au substrat et le deuxième potentiel électrique est créé dans une deuxième zone située au voisinage direct du substrat, les premières et deuxièmes zones étant adjacentes l'une à l'autre, lequel premier et deuxième potentiels possèdent un gradient dirigé vers le substrat dont la pente du premier potentiel est plus élevée que celle du deuxième potentiel. Ceci permet de mieux concentrer les substances porteuses des molécules insaturées ou sous forme de radicaux tout autour du substrat et ainsi d'augmenter la probabilité de synthétiser du diamant.

L'invention concerne également un dispositif, selon la revendication 19, pour la mise en application d'un procédé suivant l'invention.

L'invention sera maintenant décrite plus en détail à l'aide des dessins qui illustrent un exemple de réalisation d'un dispositif suivant l'invention. Dans les dessins :

la figure 1 a, b et c illustrent de façon schématique le dispositif suivant l'invention;
les figures 2 et 3 montrent des émetteurs pour produire le faisceau de photons;
la figure 4 illustre un émetteur pour produire des UV-c;
la figure 5 illustre le procédé suivant l'invention tel qu'il se produit dans le dispositif;
les figures 6 à 8 montrent des étapes du procédé; la figure 9 montre un spectre d'absorption de diamant obtenu par CVD ;
la figure 10 montre un exemple de réalisation d'un système de focalisation du plasma;
la figure 11 montre un premier et un deuxième potentiel; et
la figure 12 illustre la première zone de Brillouin de la maille d'une matière telle que le diamant.

Dans les dessins une même référence a été attribuée à un même élément ou à un élément analogue.

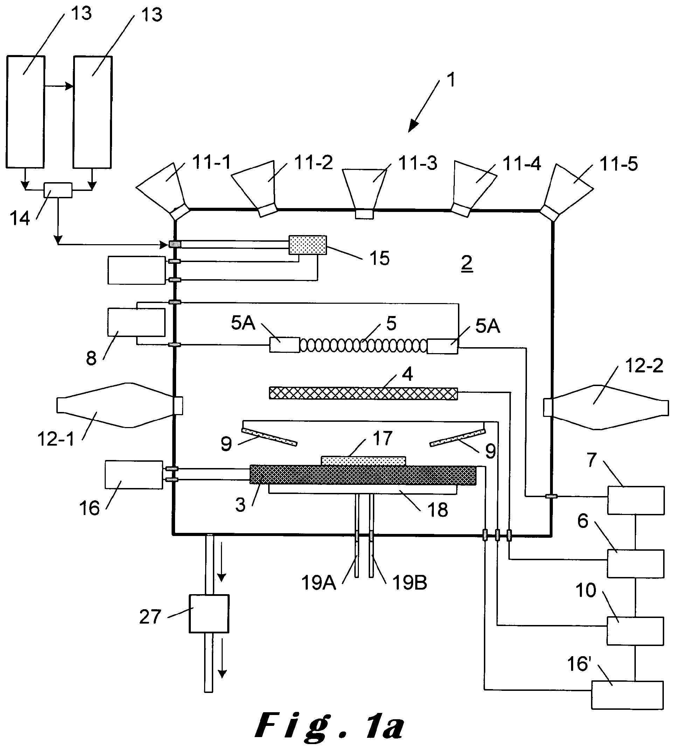

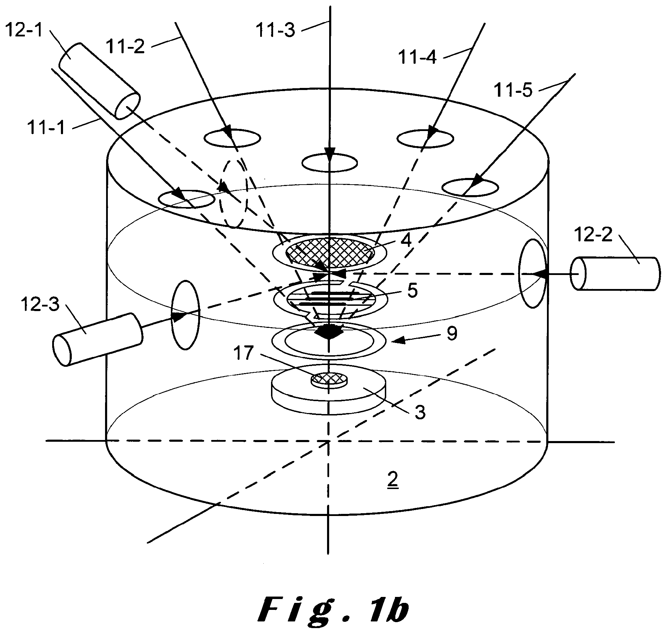

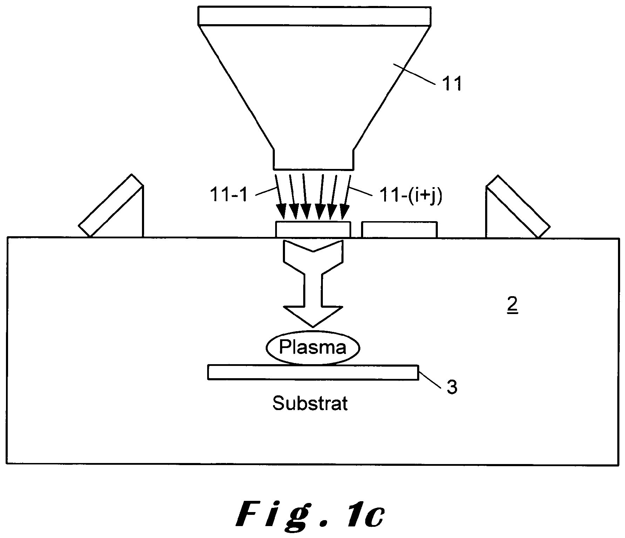

Les figures 1 a, b et c illustrent de façon schématique un exemple de réalisation d'un dispositif suivant l'invention. La figure 1 a montre la structure du dispositif, alors que la figure 1 b montre la disposition dans l'espace des éléments du dispositif. Le dispositif 1 est agencé pour l'application d'un procédé pour synthétiser une matière par dépôt chimique en phase vapeur à filament chaud (HFCVD; Hot Filament Chemical Vapour Déposition). Il sera toutefois clair que le dispositif illustré permet également tout autre procédé pour synthétiser par dépôt chimique en phase vapeur (CVD) du diamant et que l'invention n'est pas limitée au procédé HFCVD mais s'applique à tout procédé CVD.

Le dispositif 1 illustré aux figures 1, b et c comporte une chambre 2 sous vide, qui de préférence est amenée à une pression de $10^{-3}$ Torr avant de démarrer le procédé de synthèse. La mise sous vide de la chambre est réalisée de façon connue par exemple à l'aide d'une pompe. Dans la chambre se trouve un porte substrat 3, par exemple formé par un plateau, agencé à porter la matière 17 à synthétiser. Cette matière peut être toute substance compatible pour la réalisation du dépôt, comme par exemple du diamant, W, WCCo, WCNi silice, etc.

Le porte substrat est de préférence relié à une première source de tension 16 de courant alternatif pour des raisons qui seront décrites ultérieurement. Le cas échéant, le porte-substrat est également relié à une source de courant continue 16'. Le porte-substrat 3, est de préférence monté sur un plateau de refroidissement 18 servant à réguler la température du substrat. A cette fin, une entrée 19A et une sortie 19B de liquide de refroidissement sont reliées à ce plateau de refroidissement 18.

Au-dessus du substrat se trouve une grille 4 et au-dessus de la grille un filament 5. Le filament est de préférence monté entre deux collimateurs 5A, qui servent à focaliser le champ électrique pour une meilleure collimation du plasma. Les collimateurs permettent une meilleure distribution de la température, ainsi que du plasma dans la région du dépôt. Il faut noter également que l'invention n'est pas limitée à la position de la grille et du filament telle qu'illustrée aux figures 1 et b, et que ces positions peuvent être inversées.

La grille 4 est reliée à une deuxième source de tension 6 et le filament 5 à une troisième source de tension 7. La deuxième et la troisième sources de tension sont des sources de tension à courant continu. La grille peut, le cas échéant, également être reliée à une quatrième source de tension de courant alternatif (non repris dans le dessin). Le filament est également relié à une cinquième source de tension 8 qui est une source de tension de courant alternatif. Les premières, deuxièmes et troisièmes sources de tension servent à faire varier le potentiel électrique entre le substrat, la grille et le filament, alors que la cinquième source de tension 8 sert au chauffage du filament. Par la variation du potentiel électrique entre le substrat, la grille et le filament, il est possible de faire varier le champ électrique dans la chambre et ainsi de contrôler le plasma qui sera produit dans la chambre. La tension appliquée sur le filament et la grille peut varier entre 0.1 et 400 Volt en fonction de la matière à synthétiser. La grille sert essentiellement à régler le flux des substances chimiques porteuses de radicaux ou des molécules insaturées présentes dans la chambre, alors que le filament sert à réaliser l'activation du gaz.

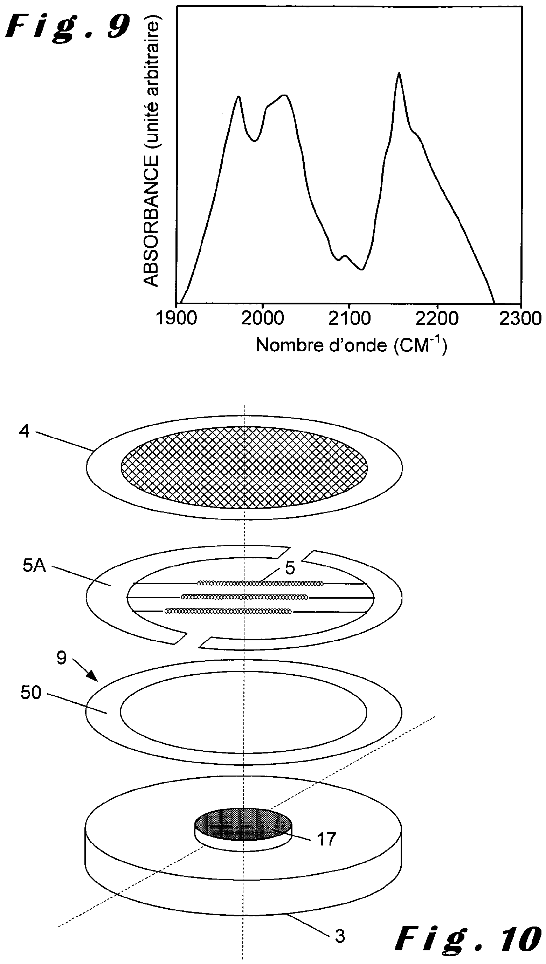

Le dispositif suivant l'invention comporte également un système 9 de focalisation du plasma placé en périphérie du substrat et agencé pour améliorer la distribution de la température et du plasma dans la région où la synthèse du diamant aura lieu et où s'effectue le dépôt. La figure 10 illustre un exemple d'un tel système 9 de focalisation du plasma. Le système de focalisation du plasma est par exemple formé par un anneau 50 placé autour du substrat et décalé vers le haut de la chambre par rapport au substrat. Le système de focalisation 9 peut également être formé par un jeu de fils en métal repliés sensiblement en forme de U inversé et placés autour du substrat. Le système de focalisation du plasma est alimenté par une sixième source de tension 10, qui fournit un courant continu. La forme d'anneau pour la focalisation du plasma en relation au filament est de préférence réalisée par deux demi-cercles placés de part et d'autre du porte-substrat. Le système 9 de focalisation du plasma est de préférence placé de façon inclinée vers le porte-substrat afin de mieux focaliser le plasma vers le substrat.

Le dispositif suivant l'invention comporte aussi des générateurs de faisceaux de photons 11-1 à 5 disposés au-dessus de la chambre et agencés pour produire des rayons énergétiques, en particulier des rayons Infra Rouge (IR), sous forme d'un faisceau de photons. Le nombre de générateurs de faisceaux de photons est déterminé par la cristallographie de la substance et n'est donc pas limité à celui repris dans les figures 1 a et b. Il est également possible, comme dans la forme de réalisation illustrée à la figure 1c, qu'il n'y a qu'un seul générateur de faisceaux de photons. Ce ou ces générateurs servent à produire des rayons énergétiques dont la fréquence est déterminée par la fonction de densité spectrale $\Psi(\omega, K)$ de la matière à synthétiser, où $\omega$ représente la fréquence et K le vecteur d'onde qui est polarisé ou non dans un plan, comme il sera décrit ci-dessous. Enfin, le dispositif est pourvu d'un générateur 2-1, 12-2 et 12-3 (ce dernier n'étant pas visible dans le dessin) de faisceaux de rayons UV-c. Ces derniers générateurs sont de préférence disposés suivant un cercle, avec chaque fois un angle de 120° entre eux pour des raisons de symétrie.

Il faut noter que pour des raisons de clarté seule la forme de réalisation des générateurs de faisceaux de photons agencés à produire des rayons Infra Rouge sera décrite. Toutefois, l'invention n'est pas limitée à cette forme de réalisation et d'autres rayons énergétiques du spectre électromagnétique qui interagissent avec la matière peuvent être utilisés (rayons X, UV, visible).

Puisqu'un plasma doit être produit à l'intérieur de la chambre 2, le dispositif suivant l'invention comporte également une entrée reliée à une source d'alimentation 13 permettant d'introduire dans la chambre une substance porteuse de carbone, en particulier sous forme de gaz porteur de carbone, et de l'hydrogène (H2). La substance qui est introduite est bien entendu en relation avec la matière à synthétiser. La source est reliée à la chambre par l'intermédiaire d'une vanne 14 de contrôle de débit agencée pour régler le débit du gaz injecté dans la chambre. Pour la formation de diamant la substance porteuse de carbone est introduite dans la chambre pour y produire un gaz comprenant des substances porteuses d'atomes de carbone réactif sous forme de radicaux ou de molécules insaturées à partir desquels la synthèse de la matière sera réalisée. Le gaz porteur de carbone est par exemple du méthane (CH4) ou de l'acétylène (C2 H2). Cette réaction de synthèse est connue en soi et est par exemple décrite dans l'article de «J.E. Butler, Y.A. Mankelevich, A. Cheesman, Jie Ma et M.N.R. Ashfold» intitulé «Understanding the chemical vapor déposition of diamond : récent progress» et paru dans Journal of Physics condensed Matter 21 , 2009. Le cas échéant le gaz peut être préchauffé à l'aide d'un chauffage 15 avant de rentrer dans la chambre. Une unité de pompage 27 du gaz est reliée à la chambre pour pomper le gaz et permettre un équilibrage de la pression de gaz qui règne à l'intérieur de la chambre. Pour la formation non revendiquée d'une autre matière que le diamant, la substance nécessaire pour la formation de ladite matière est introduite dans la chambre pour y produire un gaz comprenant des substances porteuses d'atomes de base de la matière réactive sous forme de radicaux ou de molécules insaturées à partir desquels la synthèse de la matière sera réalisée.

Au voisinage du substrat est situé la zone de dépôt. C'est dans la zone de dépôt que la réaction de synthèse a lieu et c'est pour cette raison que dans la zone de dépôt la distribution de température et la distribution des espèces chimiques à activer doivent être très homogènes.

Le procédé suivant l'invention est basé sur le phénomène physique de la résonance lors de l'excitation sélective et du couplage des états quantiques spécifiques des espèces chimiques actives et des états quantiques spécifiques du matériau à synthétiser. L'objectif de l'invention est d'augmenter le rendement du procédé de synthèse en permettant des transitions sélectives au niveau des états quantiques. La méthode suivant l'invention favorise la probabilité de la formation par synthèse d'un diamant en imposant certains des états quantiques spécifiques, qui correspondent au spectre effectif ou apparent d'absorption de ce matériau au cours des étapes réactionnelles et qui conduisent à la formation du diamant.

Le procédé suivant l'invention favorise également la probabilité de la formation d'une espèce chimique en imposant certaines transitions quantiques spécifiques correspondantes au diamant à synthétiser. Enfin, le procédé favorise la probabilité de formation d'une espèce chimique, en imposant certains états quantiques spécifiques de l'espèce chimique à synthétiser aux étapes réactionnelles pendant la formation correspondante à ladite espèce chimique.

Dans le procédé suivant l'invention on introduit dans la chambre des énergies ($E^{DA}_{st}$) qui peuvent agir à différents moments dans la réaction, ou pendant toute la réaction. Ainsi on distingue :

- $E^D_{st}$ ; qui est une énergie de dissociation dont la fonction est de rompre certaines des liaisons chimiques présentes dans la substance et de former de façon sélective, en particulier par résonance, des substances de départ ou des substances transitoires qui doivent ensuite mener à la matière à synthétiser. L'énergie de dissociation est par exemple produite par des rayons UV-c.

- $E^A_{st}$ : qui est une énergie de structuration, de forme, d'agrégation ou configuration de la structure à former: Sa fonction est de fixer la structure de la substance à former ou à synthétiser.

La fonction densité spectrale [$\Psi(\omega,K)$] de la matière à synthétiser est composée d'une somme de fonctions des densités spectrales d'états

$$\Psi(\omega,K) = \Psi_E(\omega,K) + \Psi_V(\omega,K) + \Psi_R(\omega,K) + \Psi_T(\omega,K)$$

où $\psi_E$ représente la fonction densités spectrales d'états électroniques, $\psi_V$ la fonction densités spectrales d'états vibrationnels ou phoniques, $\psi_R$ la fonction densités spectrales d'états rotationnels et $\psi_T$ la fonction densités spectrales d'états de translation. De plus amples détails sur cette fonction densité spectrale d'états pour un exemple du diamant correspondante aux états vibrationnels sont décrits dans l'article de Claude Klein, Thomas Hartnett et Ciifford Robinson, intitulé «Critical-point phonon frequencies of diamond» paru dans Physica! Review B Vol 45 N° 22 du 1 juin 1992. En particulier pour le diamant la fonction densités spectrales d'états globlaux est décrite par la somme de la fonction densités spectrales des états électroniques ($\Psi_E(\omega,K)$) et vibrationnels ($\Psi_V(\omega,K)$). Lorsque ia matière est formée par un liquide les états rotationnels doivent être pris en compte et pour un gaz les états de translation doivent être pris en compte.

Le procédé suivant l'invention fait appel à cette fonction de densité spectrale d'états ou à défaut au spectre électromagnétique effectif ou apparent d'absorption de la matière à synthétiser, voir pour exemple du diamant le spectre d'absorption repris en figure 9 de l'article de Klein et autres. Ces spectres électromagnétiques d'absorption sont des spectres intrinsèques à la matière, ou activés par défaut. Ces spectres électromagnétiques d'absorption sont également des spectres de diffusions inélastiques de photons ou de neutrons de la matière à synthétiser. Dans le spectre électromagnétique d'absorption on prélève les fréquences d'absorption (fj) qui caractérisent la matière à synthétiser et contribuent ainsi aux réactions qui mènent à la formation de la matière à synthétiser.

Ainsi, par exemple en se référant toujours à l'article de Klein et autres on prend les 17 $1 \leq i \leq 17$ niveaux d'énergie repris à la table II, correspondant au spectre à deux phonons (et (ou) table I du même article correspondant au spectre à un phonon). A l'aide de ces niveaux d'énergie et des fréquences d'absorption qui y correspondent on va former pour chacune (i) de ces fréquences fi un faisceau de photons porteur d'une quantité d'énergie $E_i = hf_i$ où h est égal à la constante de Planck. On obtient ainsi dans l'exemple du diamant dix-sept faisceaux de photons ayant chacun une quantité d'énergie Ei bien déterminée. Bien entendu le nombre de fréquences est fonction de la matière solide à synthétiser. Le choix de i=17 est lié à l'exemple de l'article de Klein et autres, mais ne limite en aucune façon l'invention.

Bien entendu on pourrait prendre toutes les fréquences du spectre de la matière à synthétiser reprises à la figure 9 dudit article. Mais en pratique il suffit de prendre les plus représentatives et celles nécessaires pour déterminer la matière. Ainsi on pourrait prendre les valeurs reprises au tableau III de l'article de R. Vogelgesang, A. Alvarenga , Hyunjung Kim, A. Ramdas et S. Rodrigues, intitulé : »Multiphonon Raman and infrared spectra of isotopically controlled diamond », paru dans Physical Review B, Volume 58, numéro 9 de septembre 1998 aux pages 5408 à 5416. Mais comme le montre ce tableau pas tous les niveaux d'énergie ont une activité dans la plage de fréquences des infrarouges et il n'est donc pas utile de produire un faisceau de photons pour ces fréquences qui n'ont pas d'activité.

L'énergie contenue dans chaque faisceau de photons représente donc l'énergie d'excitation de modes de phonons spécifiques de la matière à synthétiser. Ainsi, les substances porteuses d'atome de carbone réactif présentes dans le plasma, qui entrent en contact avec le photon et qui possèdent une fréquence d'absorption correspondant à celle des photons du faisceau vont subir, lorsqu'il s'agit d'une matière solide à synthétiser, des transitions vibrationnelles, ce qui va influer sur leur interaction avec le substrat (ou avec le solide déjà formé). Puisque l'énergie des photons correspond à celle des états phoniques du matériau à synthétiser il en résultera une interaction plus efficace et une réaction plus ciblée à la surface dudit matériau, ce qui entraînera un rendement supérieur du procédé par rapport au procédé déjà connu ou l'énergie se distribue sur toutes les fréquences de façon non sélective (électronique, vibrationnel).

Le procédé suivant l'invention fait appel au phénomène d'interaction, dans l'interphase du matériau et des substances porteuses d'atomes de carbone réactif, par l'intermédiaire des photons, pour un couplage optimal des deux systèmes.

Ces faisceaux de photons son injectés dans le plasma présent dans la chambre 2 à l'aide des générateurs 11 -i. L'énergie reprise dans chaque faisceau de photons représente donc l'énergie nécessaire pour provoquer une absorption par résonance au niveau des états phoniques. Ainsi, les substances contenant des atomes de carbone réactif présents dans le plasma qui entrent en contact avec les photons dont la fréquence d'absorption correspond à celle de l'énergie dans le faisceau de photons, vont absorber cette énergie aboutissant ainsi à une réaction de synthèse plus avantageuse de la matière solide à former. Puisque l'énergie des photons correspond chaque fois à celle des états phoniques, une réaction plus ciblée, ayant une plus grande probabilité de mener à une absorption de l'énergie des photons sera provoquée, ce qui entraînera donc un rendement supérieur du procédé par rapport au procédé connu où l'énergie couvre toutes les fréquences de façon non sélective.

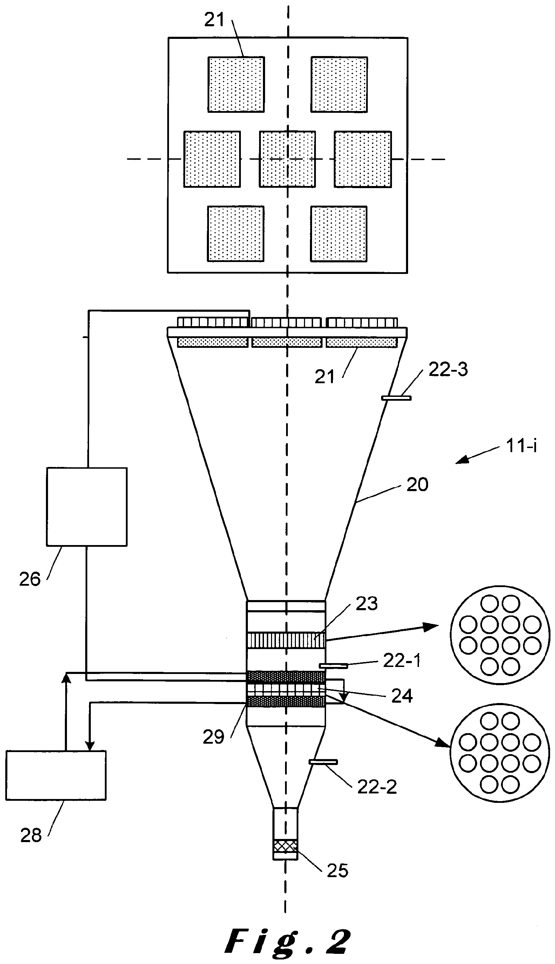

La figure 2 montre un exemple de réalisation d'un émetteur générateur (11-i) d'un faisceau de photons. Ce générateur permet de produire un faisceau de photons ayant les énergies Ei correspondantes aux fréquences f, d'absorption choisies. Le générateur comporte un corps 20, de préférence fabriqué en cuivre pour permettre un haut rendement. Ce corps possède une géométrie tronconique et comprend à sa tête un ensemble de plaques chauffantes 21 en céramique formant un émetteur Infra Rouge (IR). Dans l'exemple illustré le générateur comporte sept plaques réparties sur l'ensemble de la surface et montrées dans la partie haute de la figure. Le générateur comporte également des entrées de gaz 22, par exemple de l'argon. Ce gaz sert à réduire l'oxydation de la paroi interne, ce qui permet à son tour de maintenir un indice de réflexion élevé pour celle-ci. Le gaz réduit également l'absorption des rayons Infra Rouge produits et contribue à la génération du faisceau de photons ayant des quantités d'énergie très sélectives. Le cas échéant une pompe 28 est prévue pour la circulation du liquide dans un système de refroidissement 29.

Un premier ensemble de filtres 23 à large bande de passage est monté près de l'entrée du tube tronconique. Ces filtres sont par exemple formés par des saphirs. Au lieu d'utiliser un ensemble de filtres il est également possible d'utiliser qu'un filtre, quoique cette dernière solution soit plus onéreuse. Cet ensemble de filtres permet de sélectionner la fréquence de l'énergie à produire. Un deuxième ensemble de filtres 24 à bande de passage étroit est monté en dessous du premier filtre, de telle façon que les premiers et deuxièmes ensembles de filtres se trouvent de part et d'autre de l'entrée de gaz 22-1. Ce deuxième ensemble est constitué des filtres optiques à multi-passage permettant de sélectionner l'ensemble des fréquences f, nécessaires à la réaction de synthèse. Au bout du générateur se trouve une lentille optique 25 qui sert de collimateur au faisceau de photons. Une source d'alimentation 26 en courant électrique couplée à un régulateur permet de contrôler la température de l'émetteur.

Ainsi, pour opérer le générateur de faisceau de photons, la fréquence de l'énergie à produire est appliquée à l'aide des premiers et deuxièmes ensembles de filtres 22 et 24. Les photons sont produits par l'émetteur 21 et l'énergie fi, requise est obtenue par ajustement des ensembles de filtres 23 et 24. Ainsi sort du deuxième ensemble de filtres 24 un faisceau de photons ayant une énergie Ei = hfi, pour la fréquence fi sélectionnée. La présence de plusieurs générateurs 11 -i permet de générer à la fois plusieurs faisceaux énergies $E_j(fi)$ simultanément.

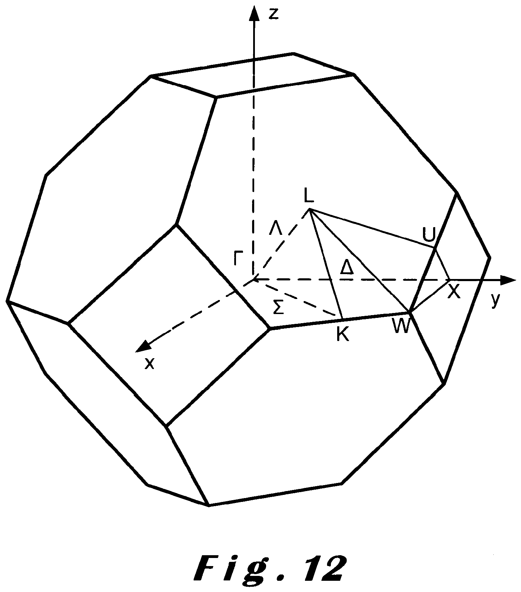

La matière à synthétiser possède une maille cristallographique à laquelle on peut associer deux jeux de vecteurs directionnels. Le premier jeu de vecteurs indique les directions normales aux principaux plans réticulaires de plus haute densité atomique déterminant les faciès possibles de ladite matière solide, par exemple dans l'exemple du diamant, l'octaèdre ou le dodécaèdre. Le second jeu de vecteurs d'onde étant constitué des vecteurs d'ondes permis pour la propagation des phonons conformément à la structure cristallographique de la matière. Ceci est par exemple décrit plus en détail dans l'article de A. Ramdas intitulé «Raman, Brillouin and infrared spectroscopy of phonons in conventional diamond» publié dans IEE de juillet 2000. La figure 12 illustre la première zone de Brillouin de la maille d'une matière telle que le diamant avec les points de haute symétrie $\Gamma$, L, X, W,$\Sigma$, $\xi$.

Ledit faisceau de photons est orienté et injecté suivant des directions indiquées par lesdits deux jeux de vecteurs directionnels. Le procédé consiste également à injecter des faisceaux de photons possédant les énergies des modes de phonon $\omega$ et orientés selon les vecteurs d'onde K correspondants, inscrits dans la zone de Brillouin, que l'on prélève sur les courbes de dispersion de ladite matière solide à synthétiser, par exemple aux points critiques et aux points de haute symétrie, en ce compris le centre de la zone noté couramment par $\Gamma$. Ces deux jeux de directions relatifs aux mailles respectives du réseau direct et du réseau réciproque, fournissent en définitive les directions choisies pour ledit faisceau de photons. En tenant compte de ces deux jeux de vecteurs, lors de l'injection du faisceau de photons on parvient à augmenter la probabilité d'interaction et on contribue ainsi à augmenter la vitesse de dépôt de la matière solide à synthétiser.

Pour augmenter le rendement de la synthèse il est utile de tenir compte de cette cristallographie et d'injecter les faisceaux de photons en suivant les directions indiquées par tes normales aux faces cristallines et (ou) également les directions correspondantes aux vecteurs d'onde autorisées pour la propagation de phonons. Il faut noter que si cette façon de procéder à la méthode suivant l'invention vient améliorer l'injection de photons décrite ci-dessus, l'injection peut également se faire directement sans tenir compte de ces directions privilégiées. Les générateurs sont montés de façon directionnelle sur ia chambre afin justement de permettre cette possibilité.

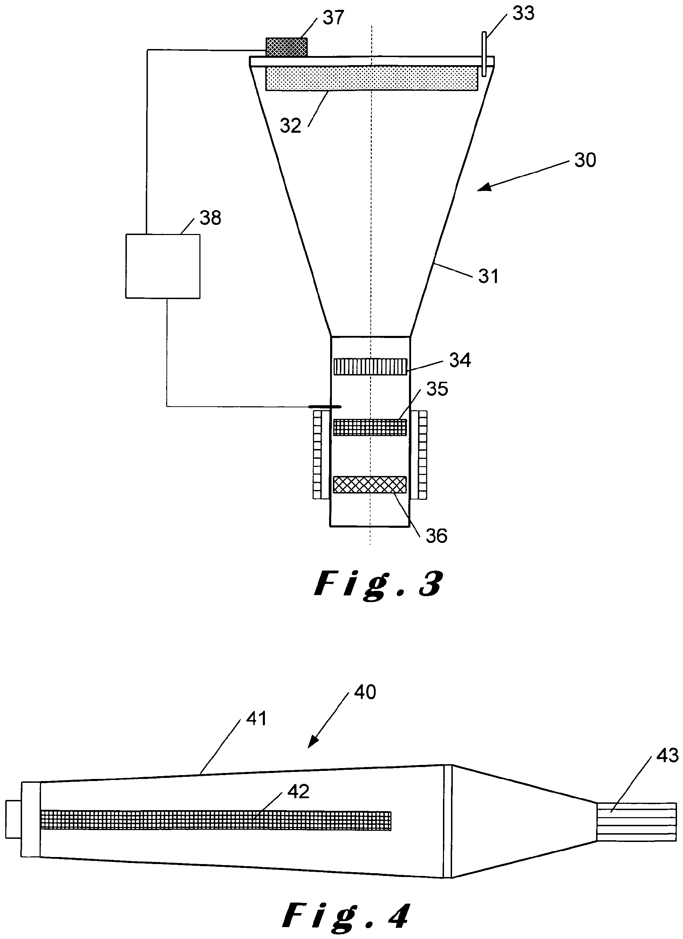

La figure 3 illustre un autre exemple de réalisation d'un générateur 30 mono-fréquence d'un faisceau de photons. Ce générateur comporte un corps d'émetteur 31 qui est également de préférence en cuivre pour permettre un indice de réflexion élevé des photons. Une plaque chauffante 32 en céramique comportant une bande étroite d'émission est montée dans la partie haute du corps ayant une géométrie tronconique. Une entrée de gaz 33 est également prévue sur la partie haute. Ce gaz joue le même rôle que celui décrit dans l'exemple de la figure 2.

Le générateur comporte un premier ensemble de filtres 34 à bande de fréquence large qui permet une présélection de la valeur de fréquence correspondant à f, par réduction de la bande passante. En même temps, ce premier filtre facilite la réduction de la chaleur produite dans le générateur. Un deuxième ensemble de filtres 35 à bande de passage étroit permet de sélectionner la fréquence fi voulue et une lentille optique 36 permet la collimation des faisceaux de photons. Enfin, l'alimentation 37 permet la fourniture en courant électrique et un régulateur 38 permet le réglage de température.

Pour davantage stimuler la synthèse de la matière, il est important qu'il y ait suffisamment de radicaux ou des molécules insaturées présentes dans le plasma. En effet, ces radicaux ou molécules insaturées sont des briques essentielles au dépôt de la matière. A cette fin, le procédé suivant l'invention comporte la production des faisceaux de rayons UV-c qui sont alors injectés dans le plasma. La figure 4 illustre un exemple de réalisation d'un tel générateur (40) de rayons UV-c. Ce générateur comporte un corps 41, de préférence fabriqué en aluminium pour permettre un indice de réflexion élevé des rayons UV-c. Une lampe 42 d'UV-c est montée à l'intérieur du corps 41. Cette lampe produit des rayons UV-c, qui sont envoyés vers un collimateur 43 en forme d'entonnoir. L'émetteur de rayons UV-c est de préférence placé sur un coté latéral de la chambre pour permettre une injection directe dans le plasma. Les rayons UV-c viendront ainsi stimuler la réaction $CH_4 \rightarrow CH^+_3 + H^-$ qui provoque ainsi une plus grande concentration de $CH^*_3$ qui vont contribuer à la synthèse de la matière voulue.

Pour encore augmenter le rendement du dépôt par synthèse de la matière, usage est fait d'un système de focalisation du plasma. La figure 10 montre une première forme de réalisation d'un tel système. Périphérique au porte-substrat 3 et décalé en hauteur par rapport au substrat 17, un anneau 50 est placé dans la chambre. L'anneau est situé en dessous du filament 5 et est relié à une source d'alimentation en courant électrique. Une deuxième forme de réalisation d'un système de focalisation du plasma peut être réalisée en remplaçant l'anneau de la figure 10 par un conducteur électrique configuré en une succession d'ondes bloc disposées en périphérie du porte-substrat 3. Tant l'anneau 50 que le conducteur électrique produisent un champ électrique dirigé vers le substrat qui va focaliser un plasma présent dans la chambre vers le substrat. Le système de focalisation du plasma se trouve entre la grille 4 et le substrat 3.

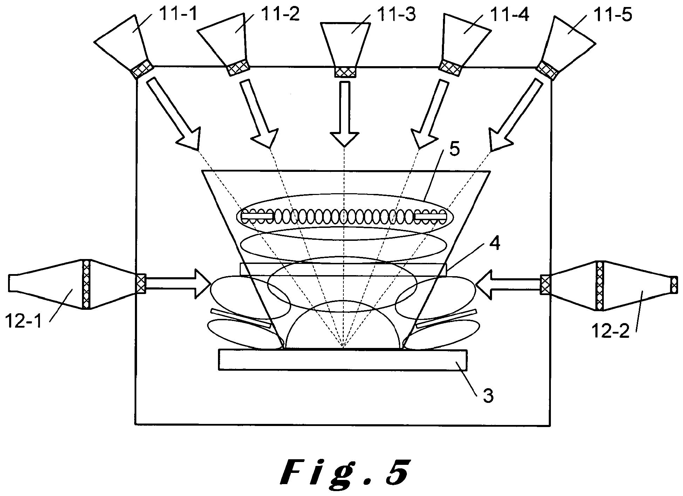

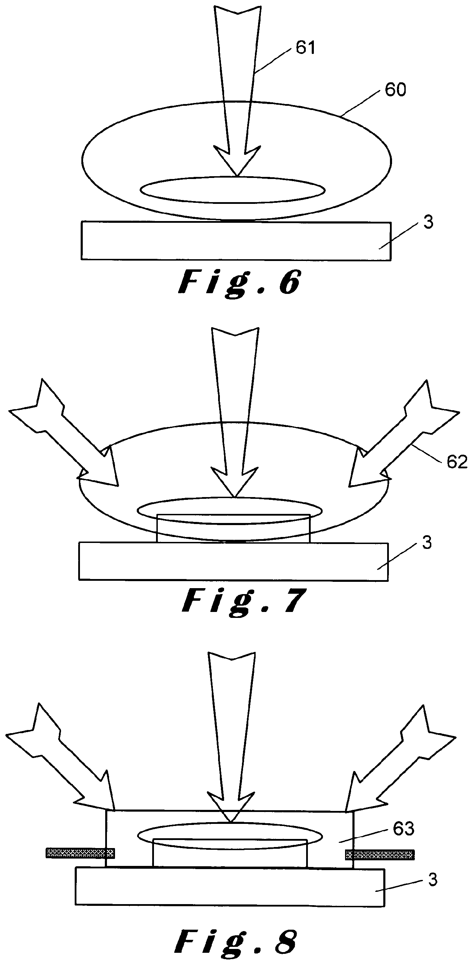

Le procédé suivant l'invention sera maintenant illustré à l'aide des figures 5 à 8 et 11. La grille 4 et le filament 5 permettent de créer un premier potentiel électrique dans une première zone RFG décalée dans le sens de la hauteur par rapport au substrat. Cette première zone est située aux alentours de la grille 4 et du filament 5. Le système de focalisation du plasma permet de créer un deuxième potentiel électrique dans une deuxième zone RD située en surface du porte-substrat 3. La première et la deuxième zones sont adjacentes l'une à l'autre afin de ne pas créer, pour ainsi dire, un vide entre le premier et le deuxième potentiels. Dans la chambre on trouve également une zone RPF du plasma autour du filament 5. Dans la première zone RFG le plasma est établi par la différence de potentiel entre le filament et la grille. Dans la zone RGC en périphérie du substrat, le plasma est établi par la différence de potentiel entre la grille et le système de focalisation 9, alors que dans la zone RCS, en dessous du système de focalisation, le plasma est établi par la différence de potentiel entre le système de focalisation et le porte-substrat.

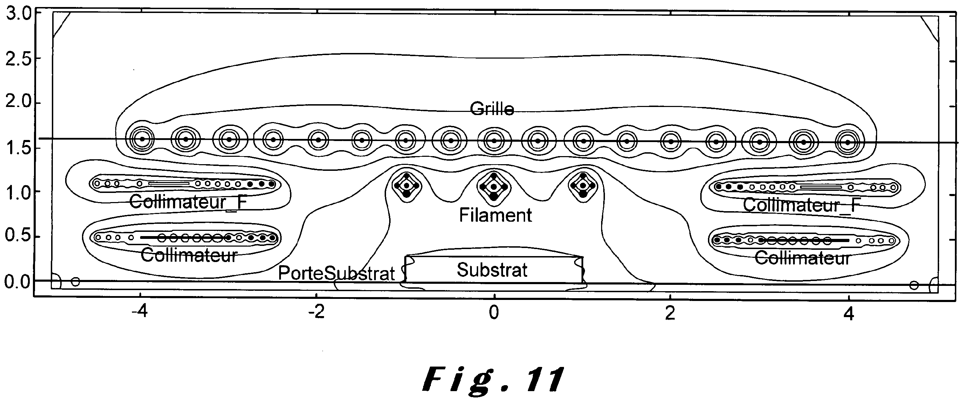

Eu égard à leur configuration et leur conception technique différente, le premier et deuxième potentiels possèdent chacun un gradient différent. Même si les deux champs électriques qui fournissent les potentiels sont dirigés vers le substrat, le taux de gradient du premier potentiel est plus élevé que celui du deuxième potentiel. La figure 11 montre la distribution du champ électrique dans la chambre. Pour faciliter la compréhension, la grille 4, le filament 5 et le substrat 3 ont été repris dans cette figure 11. Dans cette figure on voit comment le potentiel est concentré autour du substrat créant ainsi un puits de potentiel dans lequel se trouve le substrat. On voit en effet qu'autour du filament, le potentiel est concentré pour se prolonger au- dessus du porte-substrat. Ainsi, le dépôt par synthèse de la matière sera favorisé dans cette région du substrat. Autour de la grille on constatera que le champ électrique possède une configuration en boucle ovale. Dans l'exemple repris à la figure 11 la tension sur la grille est de 185V, sur le filament -25V, au porte-substrat -0,1V et le système de focalisation est à 20V. On voit également comment le potentiel produit par le système de focalisation tend à concentrer le plasma autour du porte-substrat.

Le procédé suivant l'invention sera maintenant illustré plus en détail à l'aide des figures 5 à 8. Dans la chambre 2 un plasma 60 est créé comme décrit au préalable et le gaz est introduit dans la chambre par la source d'alimentation 13. Les valeurs des premier et deuxième potentiels seront établies en fonction de la matière à synthétiser.

Sur base de la fonction de distribution spectrale ou à défaut de son spectre d'absorption de la matière à synthétiser, l'utilisateur va déterminer les différentes fréquences fi, d'absorption afin de pouvoir à l'aide des générateurs 11 produire des faisceaux de photons 61 ayant les énergies $E_i = hf_j$ nécessaires à la synthèse de la matière. Dans la figure 5 est illustré comment en zone RI les rayons énergétiques sont introduits dans la chambre. Le cas échéant on peut polariser les rayons qui sont introduits dans la chambre. Dans ce dernier cas la direction du vecteur d'onde associé à la valeur de fréquence et le plan de polarisation du vecteur d'onde associé à la cristallographie de la matière sont pris en considération. L'énergie ainsi produite sera injectée dans le plasma où elle pourra être absorbée par les substances porteuses des atomes de carbone réactif présents dans le plasma. Puisqu'à proximité du substrat et à la surface de celui-ci le plasma est focalisé, une meilleure interaction énergétique entre les substances porteuses des atomes de carbone réactif et le substrat, où la matière déjà formée est présente, sera obtenue.

Une amélioration peut être obtenue en activant les générateurs 17 de rayons UV-c qui vont exciter, de façon sélective, les substances contenues dans le plasma. Ceci doit permettre d'augmenter la production dans le plasma d'une forme sélective contenant des radicaux ou des molécules insaturées et ainsi d'augmenter la probabilité d'une absorption d'énergie. Ces rayons UV-c sont introduits en zone RAS, c'est-à-dire dans la zone de la grille. Pour l'exemple du diamant les 17 valeurs de fréquences sont injectées dans le plasma selon le jeu de vecteurs L, W,$\Sigma$ et $\xi$. Quatre faisceaux suivant la direction du vecteur L, trois faisceaux suivant la direction du vecteur W, sept faisceaux suivant la direction du vecteur $\Sigma$ et trois faisceaux suivant la direction du vecteur $\xi$. Enfin, à l'aide du système de focalisation i! est possible de former un puits de plasma 63 autour du porte-substrat (zone RD) pour ainsi focaliser les substances contenant des atomes de carbone réactif autour du substrat.

Bien que non revendiqué, le procédé n'est bien entendu pas limité à la synthèse du diamant et peut être appliquée à d'autres matières à synthétiser. Ainsi par exemple le procédé est applicable au dopage du diamant avec du Bore pour produire un supraconducteur. La condition pour l'obtention d'un supraconducteur est que la densité des atomes $n_B \rangle 3 \times 10^{20}$ atomes/cm$^3$ (>600 ppm). Pour obtenir un supraconducteur le procédé suivant l'invention est au départ similaire à celui décrit pour la synthèse du diamant. Pour réaliser le dopage du diamant avec du Bore on introduit dans la chambre un gaz porteur du Bore, comme par exemple du trimethylborane ou de Boron-trichloride ou diborane, en particulier de diborane (C2H6) en proportion de 0.01 -200 ppm par rapport au H2, plus particulièrement de 1 ppm à 20 ppm. Ce gaz porteur de Bore est par exemple introduit lorsque la couche de diamant possède déjà une épaisseur d'au moins 1 $\mu$m, en particulier d'environ 1 à 5 $\mu$m. On injecte également dans la chambre après la synthèse physico-chimique par résonance du diamant, un deuxième faisceau de photons à la fréquence correspondante à l'interaction électron-phonon qui provoque la supraconductivité. En particulier, on divise le deuxième faisceau de photons en un premier et un second fragment du deuxième faisceau et on injecte dans le plasma les deux fragments de faisceaux de photons correspondants à la fréquence de phonon dû à la présence de Bore et qui mène à l'apparition de la supraconductivité. Plus particulièrement le premier fragment du deuxième faisceaux de photons suivant la direction LO($\Gamma{\rightarrow}$L et $\Gamma{\rightarrow} \xi$), et le second fragment du faisceaux de photons suivant la direction $\xi$, du jeu de vecteurs directionnels L, W,$\Sigma$, $\xi$ avec un décalage de 4meV par rapport à la valeur du diamant non dopée. De plus amples détails sur le mode phonon LO sont repris dans l'article de M. Hoesch et autres intitulé «Discovery of phonons causing superconductivity in diamonds looking for room température - superconductors in diamonds» paru dans JAEA R&D Review 2007, page 45.

Une éventuelle réduction de la puissance des différents faisceaux de photon correspondante au dépôt du diamant peut être envisagée, ceci proportionnelle à la différence d'énergie pour les liaisons de type B-C par rapport C-C. Cette réduction permet que la croissance du diamant ne domine pas la formation de ia supraconductivité et facilite ou pondère ainsi le processus de substitution Carbone (C) par le Bore (B).

Une autre application du procédé consiste à doper du diamant avec du Bore pour produire un semi-conducteur du type p. Une condition pour l'obtention d'un semi-conducteur est que la densité des atomes est de $n_B < 1 \times 10^{20}$ atomes /cm$^3$ (<600ppm). On utilise un gaz porteur de Bore similaire à celui utilisé pour former le supraconducteur mais avec une quantité de 0.01-100 ppm par rapport au H2, en particulier 0.1 ppm à 10 ppm. On injecte également dans la chambre après la synthèse physico- chimique par résonance du diamant, un troisième faisceau de photons à la fréquence correspondante à l'interaction électron-phonon qui provoque la semi-conductivité. En particulier on divise le troisième faisceau de photons en un premier et un second fragment du troisième faisceau et on injecte dans le plasma les fragments de faisceaux de photons correspondants à la fréquence de phonon dû à la présence de Bore et qui mène à l'apparition de la semi-conductivité. Ainsi on injecte dans le plasma les cinq faisceaux de photons correspondants à la fréquence des phonons dû à la présence de Bore, responsable de la semi-conductivité. Le premier fragment formé de trois faisceaux qui sont injectés suivant la direction L et le second fragment comprend deux faisceaux qui sont injectés suivant la direction $\xi$, du jeu de vecteurs directionnels L, W, $\Sigma$, $\xi$. Tout comme pour la réalisation des supraconducteurs une éventuelle réduction de la puissance peut être envisagée.

Encore une autre application du procédé consiste à doper du diamant avec de l'azote (N) pour produire un semiconducteur du type n. Une condition pour l'obtention d'un semi-conducteur est que la densité des atomes est de 25 à 2 500ppm. On utilise un gaz porteur d'azote, comme par exemple de N2, NH3, $CH_3NH_2$, en particulier le N2, avec un ratio de 0.1 à 1 de N2 par rapport au CH4. On introduit également dans la chambre après la synthèse physico-chimique par résonance du diamant, les photons à la fréquence correspondante à l'interaction électron-phonon qui provoque la semi-conductivité de type n. En particulier on injecte dans le plasma suivant le jeu de vecteurs directionnels les faisceaux de photons correspondants à la fréquence de phonon dû à la présence de l'azote pour de centre type C, et (ou) les trois faisceaux de photon correspondants à la fréquence de phonon dû à la présence de l'azote pour l'agrégat type A, et (ou) les quatre faisceaux de photons correspondants à la fréquence de phonon dû à la présence de l'azote pour l'agrégat type B.). Tout comme pour la réalisation des semiconducteurs de type p, une éventuelle réduction de la puissance peut être envisagée.

Le procédé permet également de doper le diamant avec du phosphore pour produire un semi-conducteur de type n. On utilise un gaz porteur de phosphore, comme par exemple le phosphane, (PH3), avec un ratio molaire phosphore/carbone de 4* $10^{-2}$ à 4* $10^{-5}$ , en particulier de 2* $10^{-2}$ à 1* $10^{-3}$. On introduit également dans la chambre après la synthèse physico-chimique par résonance du diamant, un quatrième faisceau de photons à la fréquence correspondante à l'interaction électron- phonon qui provoque la semi-conductivité de type n. En particulier on injecte dans le plasma suivant le jeu de vecteurs directionnels les faisceaux de photons localisés à 523meV et 562 meV et correspondants à la fréquence de phonon dû à la présence de phosphores dans le réseau cristallin et responsable de la semi-conductivité. Une éventuelle réduction de la puissance peut être envisagée.

Le procédé permet également de former par dopage un semi-conducteur de type Si-Ge (Silicium Germanium). Il faut noter que dans l'exemple du dopage du Si par le Ge, l'épitaxie du Ge sur le Si et îa formation d'alliage de type $Si_{1-x} Ge_x$, dans le processus de CVD, mène à l'apparition de tension dans l'interface et à l'intérieur du cristal dû à la différence entre la constante du réseau du Si et celle du Ge. Ces tensions sont une source de défaut dans la structure cristalline. Aussi généralement l'hétéro épitaxie du Ge sur le Si débute par l'apparition des îles de Ge sur le Si. Ces îles sont en forme de pyramide et des pics qui peuvent mener jusque la formation des agrégats de Ge. Ceci a pour conséquence de former un dépôt inhomogène.

Un dépôt Si et de Ge est actuellement considéré de haute qualité si la densité de défaut dû à l'apparition de telles déformations est plus petite que 0.3 particules/cm2 avec une faible densité de dislocations plus petites que $10^6$ /cm$^2$. Le procédé suivant l'invention, permet de former un dépôt Si-Ge qui aura moins d'imperfections telles que décrites et qui peut même les éliminer. A cette fin le procédé pour un dépôt de Si-Ge comporte :

(a) Une étape de dépôt chimique en phase vapeur (CVD) du Silicium sur un substrat de silicium pur ou sur un substrat vierge, à une température située entre 500 °C et 600 °C, de préférence à une température (T0) de 500°C, en présence d'Hydrogène. La pression dans la chambre est de préférence de 0.01 mbar à 1000 mbar, en particulier de 0.01 mbar à 1000 mbar, plus particulièrement de 1 mbar à 800 mbar. Comme gaz précurseur de Silicium on utilise le, SiH2CI2, le SiHCl3, le SiCl4 ou le Si(CH3)4 en particulier SiH4, jusqu'à l'obtention d'une épaisseur de couche de 3nm à 5nm de préférence. Un mélange d'un ou de plusieurs de ces gaz précurseurs peut également être envisagé. Pour obtenir une vitesse de dépôt plus élevée et un dépôt de qualité supérieure à celle du procédé de base, on injecte dans la chambre en pointant vers le substrat et suivant le jeu de vecteurs directionnels L, W, $\Sigma$, $\xi$ le faisceau de photons correspondant à la fréquence du phonon dû à la liaison Si-Si. Après avoir obtenu l'épaisseur de la couche désirée, l'apport du SiH4 est arrêté, ainsi que la température du faisceau de photon est abaissée jusqu'à 400° C à 550° C, de préférence de 430° C à 460° C en présence d'Hydrogène. La pression dans la chambre est de préférence de 0.01 mbar à 1000 mbar, en particulier de 1 mbar à 800 mbar ;

(b) Une étape de stabilisation de la température du substrat à une première température (T1) de 400° C à 550° C, de préférence de 430° C à 460° C, plus particulièrement de 450° C en présence d'Hydrogène. La pression dans la chambre est de préférence de 0.01 mbar à 1000 mbar, en particulier de 1 mbar à 800 mbar;

(c) Une étape de dépôt chimique en phase vapeur (CVD) du germanium à la première température, dite T1 sur le substrat de Silicium pur ou sur le substrat de Silicium déjà obtenu après la CVD du Silicium, jusqu'à l'obtention d'une épaisseur de couche en germanium prédéterminée, ou une épaisseur de couche finale désirée obtenue sur la couche du Silicium, le gaz précurseur du germanium est de préférence GeH4. On injecte alors dans la chambre en pointant le substrat, suivant le jeu de vecteurs directionnels L, W, $\Sigma$, $\xi$ le faisceau de photons correspondant à la fréquence du phonon dû à la Maison Ge-Ge et le faisceau de photons correspondant à la fréquence du phonon dû à la liaison Si- Ge, Ce dernier agira pendant la formation des premières couches atomiques du Ge, c'est-à-dire pendant la formation de l'interface Si- Ge. Par la suite, la puissance du faisceau de photons correspondant à cette liaison (Si-Ge) sera diminuée, voir même mis à zéro, mais en maintenant la puissance du faisceau de photon correspondant à la liaison Ge-Ge. Ceci permettra d'obtenir une réduction du nombre des défauts dans le dépôt, c'est-à-dire obtenir un dépôt de qualité supérieure avec une vitesse de dépôt plus élevée. Cette étape est réalisée en présence d'hydrogène. La pression dans la chambre est de préférence de 0.01 mbar à 1000 mbar en particulier de 1 mbar à 800 mbar;

et, les étapes optionnelles

(d1)-une étape dans laquelle le dépôt CVD du germanium et le faisceau de photons correspondant à la fréquence du phonon dû à la liaison Ge-Ge est arrêté, à une température inférieure de la température (T2) jusqu'à une troisième température (T3) de 500° C à 600° C, de préférence de 540 à 560° C, en particulier 550° C, étape réalisée en présence d'Hydrogène. La pression dans la chambre est de préférence de 0.01 mbar à 1000 mbar en particulier de 1mbar à 800 mbar;

(d2)-une étape de dépôt CVD à la troisième température (T3) d'un alliage $Si_{1-x}Ge_x$ , où $x \leq 0.9$, jusqu'à l'obtention d'une couche intermédiaire de $Si_{1-x}Ge_x$ ayant l'épaisseur désirée. Le gaz précurseur du germanium est de préférence du GeH4. Le gaz précurseur pour le Silicium est SiH2CI2, SiHCl3, SiCl4 et Si(CH3)4 en particulier SiH4. On injecte ensuite dans la chambre en pointant le substrat et suivant le jeu de vecteurs directionnels L, W,$\Sigma$, $\xi$ le faisceau de photons (IR), [et/ ou] les deux faisceaux de photons (IR et Raman) correspondant aux fréquences des phonons dû à la liaison Si-Ge. Cette étape est réalisée en présence d'Hydrogène. La pression dans la chambre est de préférence de 0.01 mbar à 1000 mbar en particulier de 1 mbar à 800 mbar;

(d3) une étape de transition, à la troisième température (T3), dans laquelle le dépôt CVD de l'alliage $Si_{1-x}Ge_x$ passe à un dépôt CVD du germanium pur. Le débit du gaz précurseur du Silicium est arrêté, pour réaliser le passage vers l'étape suivante. On arrête également le (les) faisceau de photons correspondant à la fréquence du phonon dû à la liaison Si-Ge, pour injecter le faisceau de photons correspondant à la fréquence du phonon dû à la liaison Ge-Ge. Le passage du faisceau de photons correspondant à la fréquence du phonon dû à la liaison Si-Ge vers photon correspondant la fréquence du phonon dû à la liaison Ge- Ge doit se faire de préférence de façon synchronisée, de préférence par décrément-incrément simultané de la puissance étape réalisée en présence d'Hydrogène, a pression dans la chambre est de préférence de 0.01 mbar à 1000 mbar en particulier de 1 mbar à 800 mbar;

(d4)- une étape dans laquelle le dépôt CVD du germanium est maintenu à cette température (T3) de manière à obtenir le dépôt du germanium comme couche supérieure et $Si_{1-x}Ge_x$ comme une couche intermédiaire. Pendant cette étape le faisceau de photons correspondant à la fréquence du phonon dû à la liaison Ge-Ge est maintenu. Cette étape est réalisée en présence d'Hydrogène et la pression dans la chambre est de préférence de 0.01 mbar à 1000 mbar de préférence de 1 mbar à 800 mbar;

(d5)-une étape dans laquelle la température de dépôt CVD de germanium est augmentée de la troisième température (T3) jusqu'à une quatrième température (T4) de 750 à 850° C, de préférence 800 à 850° C. Pendant cette étape le faisceau de photons correspondant à la fréquence du phonon dû à la liaison Ge-Ge est maintenu. T4 de préférence égal à T2, et l'étape est réalisée en présence d'Hydrogène, la pression dans la chambre est de préférence de 0.01 mbar à 1000 mbar en particulier de 1 mbar à 800 mbar;

(e) Une étape d'incrémentation de la température du dépôt chimique en phase vapeur (CVD) du germanium de la première température (T1) à une deuxième température (T2) limitée à 750° C à 850° C, de préférence de 800° C à 850° C. Cette étape est réalisée sans la présence du faisceau de photons correspondant à la fréquence du phonon dû à la liaison Ge-Ge. Cette étape est toutefois réalisée en présence d'Hydrogène. La pression dans la chambre est de préférence de 0.01 mbar à 1000 mbar en particulier de 1 mbar à 800 mbar;

(f) Poursuite du CVD du germanium à la deuxième température (T2) jusqu'à l'épaisseur désirée de la couche de germanium. Le faisceau de photons correspondant à la fréquence du phonon dû la liaison Ge-Ge est maintenue. Cette étape est réalisée en présence d'Hydrogène et la pression dans la chambre est de préférence de 0.01 mbar à 1000 mbar en particulier de 1 mbar à 800 mbar.

**Revendications**

1. Procédé pour synthétiser du diamant par dépôt chimique en phase vapeur (CVD), suivant lequel on crée dans une chambre sous vide un plasma au voisinage d'un substrat agencé à porter le diamant à synthétiser, et suivant lequel on introduit dans la chambre un gaz porteur de carbone, en particulier du CH4 ou du C2H2, et du H2 , afin de produire dans la chambre un gaz comprenant des substances porteuses d' atomes de carbone réactif sous forme de radicaux ou de molécules insaturées à partir desquels la synthèse du diamant sera réalisée, **caractérisé en ce que** les spectres électromagnétiques d'absorption et de diffusion inélastique du diamant à synthétiser sont utilisés pour prélever dans ces spectres les fréquences d'absorption qui contribuent aux réactions qui mènent à la formation du diamant à synthétiser, et **en ce que** l'on produit des rayons énergétiques sous forme d'un faisceau de photons porteur de quantités d'énergie déterminées par chacune des fréquences correspondant auxdites fréquences d'absorption et de diffusion inélastique, lequel faisceau de photons est injecté dans le plasma où, pour des états énergétiques du diamant, une absorption de ces photons ayant l'énergie correspondant à ces états énergétiques est réalisée par lesdits gaz porteur des atomes de carbone réactif.

2. Procédé suivant la revendication 1 **caractérisé en ce que** des rayons Infra Rouge sont utilisés en tant que rayons énergétiques pour réaliser un couplage entre les états énergétiques des radicaux ou des molécules insaturées et les états énergétiques des phonons du diamant

3. Procédé suivant la revendication 1, **caractérisé en ce que** des rayons X, UV, et visibles sont utilisés en tant que rayons énergétiques.

4. Procédé suivant l'une des revendications 1 à 3, **caractérisé en ce que** le diamant à synthétiser comporte une maille cristallographique qui détermine un ensemble de facies et qui est représentée par deux jeux de vecteurs directionnels, le premier indiquant les directions normales aux principaux plans réticulaires de plus haute densité atomique déterminant les facies possibles du diamant, le second étant constitué des vecteurs d'ondes permis pour la propagation des phonons en fonction de la structure cristallographique du diamant, ledit faisceau de photons étant orienté et injecté suivant des directions indiquées par lesdits deux jeux de vecteurs directionnels.

5. Procédé suivant l'une des revendications 1 à 4, **caractérisé en ce qu'**un faisceau de rayons UV-c est injecté dans le plasma.

6. Procédé suivant l'une des revendications 1 à 5, **caractérisé en ce que** le plasma est produit par la création d'un champ électrique dans la chambre sous vide, ledit champ électrique étant créé à l'aide d'un premier et d'un deuxième potentiels électriques, ledit premier potentiel électrique est créé dans une première zone décalée dans le sens de la hauteur par rapport au substrat et le deuxième potentiel électrique est créé dans une deuxième zone située au voisinage direct du substrat, la première et la deuxième zones étant adjacentes l'une à l'autre, lequel premier et deuxième potentiels possèdent un gradient dirigé vers le substrat dont le taux de gradient du premier potentiel est plus élevé que celui du deuxième potentiel.

7. Procédé suivant la revendication 6, **caractérisé en ce que** le deuxième potentiel est créé à l'aide d'un générateur placé en périphérie du substrat.

8. Procédé suivant la revendication 6 ou 7, **caractérisé en ce que** le premier potentiel est créé à l'aide d'une grille et d'un filament placés au-dessus du substrat.

9. Procédé suivant l'une des revendications 1 à 8, **caractérisé en ce que** le substrat est maintenu à une température prédéterminée durant le dépôt du diamant à synthétiser.

10. Procédé suivant l'une des revendications 1 à 9, **caractérisé en ce que** le dépôt est réalisé en phase vapeur à chaud filament.

11. Procédé suivant l'une des revendications 1 à 10, **caractérisé en ce que** lorsque la couche du diamant à synthétiser possède une épaisseur d'au moins 1pm on dope le diamant en injectant dans la chambre un gaz porteur de Bore en une proportion de 0,01 à 200ppm par rapport au H2, et **en ce que** l'on injecte dans le plasma un deuxième faisceau de photons ayant une fréquence qui correspond à une interaction électron- phonon pour provoquer une supraconductivité du diamant.

12. Procédé suivant la revendication 11, **caractérisé en ce que** le deuxième faisceau de photons est divisé en un premier fragment de faisceau injecté suivant la direction Lo ($\Gamma$->L et $\Gamma$->$\xi$)et un second fragment injecté suivant la direction $\xi$,d'un jeu de vecteurs directionnels L, W, $\Sigma$, $\xi$ avec un décalage de 4meV par rapport à la valeur du diamant non dopé.

13. Procédé suivant l'une des revendications 1 à 10, **caractérisé en ce que** lorsque la couche du diamant à synthétiser possède une épaisseur d'au moins 1$\mu$m on dope le diamant en injectant dans la chambre un gaz porteur de Bore en une proportion de 0,01 à 100ppm par rapport au $H_2$, et **en ce que** l'on injecte dans le plasma un troisième faisceau de les photons ayant une fréquence correspondante à une interaction électron-phonon pour provoquer une semi-conductivité du diamant.

14. Procédé suivant la revendication 13, **caractérisé en ce que** le troisième faisceau de photons est divisé en un premier fragment de faisceau injecté suivant la direction L et un second fragment injecté suivant la direction $\xi$ du jeu de vecteurs directionnels L, W, $\Sigma$, $\xi$.

15. Procédé suivant l'une des revendications 1 à 10, **caractérisé en ce que** lorsque la couche du diamant à synthétiser possède une épaisseur d'au moins 1 $\mu$m on dope le diamant en injectant dans la chambre un gaz porteur d'azote avec un ratio de 0.1 à 1 d'azote par rapport au CH4 et **en ce que** l'on injecte dans le plasma un quatrième faisceau de les photons ayant une fréquence correspondante à une interaction électron-phonon qui provoque la semi-conductivité de type n.

**16.** Procédé suivant la revendication 15, **caractérisé en ce que** le quatrième faisceau de photons est injecté dans le plasma suivant le jeu de vecteurs directionnels correspondant à la fréquence de phonon dû à la présence de l'azote pour de centre type C, et/ou suivant trois faisceaux de photon correspondant à la fréquence de phonon dû à la présence de l'azote pour l'agrégat type A, et/ou suivant quatre faisceaux de photons correspondants à la fréquence de phonon dû à la présence de l'azote pour l'agrégat type B.

**17.** Procédé pour former par dépôt chimique en phase vapeur un semi-conducteur de type Si-Ge, **caractérisé en ce que** le dépôt est réalisé dans une chambre dans laquelle est créé un plasma et qu'il comporte :

- un dépôt chimique en phase vapeur de Silicium sur un substrat à une température située entre 500° et 600° C en présence d'hydrogène et ayant la chambre maintenue sous une pression située entre 0,01 à 1 000mbar, ledit dépôt étant réalisé en injectant dans la chambre un faisceau de photons correspondant à la fréquence du phonon dû à la liaison Si-Si jusqu'à ce que la couche déposée de Silicium possède une épaisseur d'au moins 3nm;
- une stabilisation de la température du substrat à une première température située entre 400° et 550° C;
- un dépôt chimique en phase vapeur de Germanium sur la couche de Si à une température située entre 400° et 550° C jusqu'à l'obtention d'une couche de Ge à une épaisseur prédéterminée avec injection dans la chambre dans un premier temps d'un faisceau de photons correspondant à la fréquence du phonon dû à la liaison Si-Ge et dans un deuxième temps d'un autre faisceau de photons correspondant à la fréquence du phonon dû à la liaison Ge-Ge;
- une incrémentation de la température du dépôt chimique en phase vapeur à une valeur située entre 750° et 850° C en présence d'hydrogène;
- le maintien de l'injection d'un faisceau de photons correspondant à une fréquence du phonon dû à la liaison Ge-Ge jusqu'à l'obtention d'une épaisseur de couche prédéterminée.

**18.** Procédé suivant la revendication 17, **caractérisé en ce qu'**on injecte le faisceau de photons suivant un jeu de vecteurs directionnels du Silicium.

**19.** Dispositif pour synthétiser du diamant par dépôt chimique en phase vapeur (CVD), le diamant à synthétiser comportant une cristallographie avec un ensemble de faces possibles, représentée par un jeu de vecteurs directionnels ou chaque vecteur indique une direction normale à une face donnée du diamant, lequel dispositif comprend

- une chambre (2) sous vide comprenant

* un porte substrat (3) agencé à porter le diamant à synthétiser et
* un générateur de plasma agencé pour produire dans la chambre un plasma au voisinage du porte substrat,
* un système (9) de focalisation du plasma agencé pour améliorer la distribution de la température et du plasma dans la région de synthèse et de dépôt du diamant,
* une entrée d'introduction dans la chambre d'un gaz porteur de carbone, laquelle chambre est agencée pour y produire à partir du gaz porteur de carbone et de **H2** un gaz comprenant des radicaux ou des molécules sous forme insaturée à partir duquel la synthèse du diamant sera réalisée, lequel dispositif comporte,

- un générateur 11-i d'un faisceau de photons (11-1 à 5), en particulier des rayons Infra Rouge et/ou des rayons X, UV et visibles, monté sur la chambre, le dit faisceau de photon étant porteur de quantités d'énergie déterminées par chacune des fréquences correspondant à une fréquence d'absorption prélevée dans un spectre électromagnétique d'absorption et de diffusion inélastique du diamant à synthétiser, **caractérisé en ce que** ledit générateur d'un faisceau de photons est monté de façon directionnelle sur la chambre de telle façon à ce que ledit faisceau produit est injecté dans la chambre, dans le plasma, sous un angle qui correspond à la fois aux vecteurs directionnels donnés du diamant et au vecteur d'onde de la zone de Brillouin associée à l'énergie du mode de phonon en ce compris le mode au centre de zone, déterminant l'énergie contenue dans le faisceau de photons.

**20.** Dispositif suivant la revendication 18 ou 19, **caractérisé en ce qu'**il comporte un autre générateur agencé pour produire un faisceau de rayons UV-c, lequel autre générateur est monté sur la chambre pour permettre une injection des rayons UV-c dans le plasma généré par ledit générateur de plasma.

**21.** Dispositif suivant l'une des revendications 19 à 20, **caractérisé en ce que** le système de focalisation (9) du plasma monté en périphérie du porte substrat.

**22.** Dispositif suivant la revendication 21, **caractérisé en ce que** le système de focalisation du plasma est formé par un anneau.

**23.** Dispositif suivant la revendication 21, **caractérisé en ce que** le système de focalisation du plasma est formé par un fil disposé sous forme d'une succession d'ondes bloc autour du substrat.

**Patentansprüche**

**1.** Verfahren zum Synthetisieren von Diamanten mittels Gasphasenabscheidung (CVD), nach dem in einer Vakuumkammer ein Plasma in der Nachbarschaft eines Substrats erzeugt wird, das zum Tragen des zu synthetisierenden Diamanten angeordnet wird und nach dem in die Kammer ein Kohlenstoffträgergas, insbesondere CH4 oder C2H2 und H2, eingeführt wird, um in der Kammer ein Gas zu produzieren, das Trägersubstanzen aus reaktiven Kohlenstoffatomen in Form von Radikalen oder ungesättigten Molekülen umfasst, aus denen die Synthese des Diamanten durchgeführt wird, **dadurch gekennzeichnet, dass** die elektromagnetischen Absorptions- und unelastischen Verteilungsspektren des zu synthetisierenden Diamanten verwendet werden, um aus diesen Spektren die Absorptionsfrequenzen zu entnehmen, die zu den Reaktionen beitragen, die zur Bildung des zu synthetisierenden Diamanten führen, und dass Energiestrahlen in Form eines Trägerphotonen-Strahlenbündels von Energiemengen erzeugt werden, die mittels jeder Frequenz bestimmt werden, die den genannten Absorptions- und unelastischen Diffusionsfrequenzen entsprechen, wobei das genannte Photonen-Strahlenbündel in das Plasma eingespritzt wird, wo bei Energiezuständen des Diamanten eine Absorption dieser Photonen, die die Energie aufweisen, die diesen Energiezuständen entspricht, mittels der genannten Trägergase der reaktiven Kohlenstoffatome durchgeführt wird.

**2.** Verfahren gemäß Anspruch 1, **dadurch gekennzeichnet, dass** Infrarotstrahlen als Energiestrahlen zum Durchführen einer Kopplung zwischen den Energiezuständen der Radikalen oder der ungesättigten Moleküle und den Energiezuständen der Phononen des Diamanten verwendet werden.

**3.** Verfahren gemäß Anspruch 1, **dadurch gekennzeichnet, dass** X-, UV- und sichtbare Strahlen als Energiestrahlen verwendet werden.

**4.** Verfahren gemäß einem der Ansprüche 1 bis 3, **dadurch gekennzeichnet, dass** der zu synthetisierende Diamant eine kristallografische Masche umfasst, die eine Gruppe von Facetten bestimmt und die mittels zwei Richtungsvektorsätzen dargestellt wird, wobei der erste die normalen Richtungen für die Hauptgitterebenen mit der höchsten Atomdichte angibt, die die möglichen Facetten des Diamanten bestimmen, wobei der zweite aus Wellenvektoren gebildet wird, die für die Verbreitung der Phononen in Abhängigkeit von der kristallographischen Struktur des Diamanten zugelassen werden, wobei das genannte Phononenstrahlenbündel gemäß Richtungen ausgerichtet und eingespritzt wird, die von den genannten Richtungsvektorsätzen angegeben werden.

**5.** Verfahren gemäß einem der Ansprüche 1 bis 4, **dadurch gekennzeichnet, dass** ein UV-c-Strahlenbündel in das Plasma eingespritzt wird.

**6.** Verfahren gemäß einem der Ansprüche 1 bis 5, **dadurch gekennzeichnet, dass** das Plasma durch die Erzeugung eines elektrischen Feldes in der Vakuumkammer erzeugt wird, wobei das genannte elektrische Feld mittels eines ersten und eines zweiten elektrischen Potenzials erzeugt wird, wobei das genannte erste elektrische Potenzial in einem ersten Bereich erzeugt wird, der in der Richtung der Höhe in Bezug auf das Substrat versetzt ist, und das zweite elektrische Potenzial in einem zweiten Bereich erzeugt wird, der in direkter Nachbarschaft des Substrats angeordnet ist, wobei der erste und der zweite Bereich aneinander anliegend sind, wobei das erste und das zweite Potenzial einen Gradienten besitzen, der zum Substrat ausgerichtet ist, dessen Gefälle des ersten Potenzials höher ist als der des zweiten Potenzials.

**7.** Verfahren gemäß Anspruch 6, **dadurch gekennzeichnet, dass** das zweite Potenzial mithilfe eines Generators erzeugt wird, der an der Peripherie des Substrats angeordnet wird.

**8.** Verfahren gemäß Anspruch 6 oder 7, **dadurch gekennzeichnet, dass** das erste Potenzial mithilfe eines Gitters und eines oberhalb des Substrats angeordneten Glühfadens erzeugt wird.

**9.** Verfahren gemäß einem der Ansprüche 1 bis 8, **dadurch gekennzeichnet, dass** das Substrat während des Abscheidens des zu synthetisierenden Diamanten bei einer vorbestimmten Temperatur gehalten wird.

10. Verfahren gemäß einem der Ansprüche 1 bis 9, **dadurch gekennzeichnet, dass** das Abscheiden in der Gasphase mit heißem Glühfaden durchgeführt wird.

11. Verfahren gemäß einem der Ansprüche 1 bis 10, **dadurch gekennzeichnet, dass**, wenn die Schicht des zu synthetisierenden Diamanten eine Dicke von mindestens 1 pm besitzt, der Diamant dotiert wird, indem in die Kammer ein Borträgergas in einem Verhältnis von 0,01 zu 200 ppm in Bezug auf das H2 eingespritzt wird und dass in das Plasma ein zweites Photonenstrahlenbündel mit einer Frequenz eingespritzt wird, die einer Interaktion Elektron-Photon entspricht, um eine Supraleitfähigkeit des Diamanten hervorzurufen.

12. Verfahren gemäß Anspruch 11, **dadurch gekennzeichnet, dass** das zweite Photonenstrahlenbündel in ein erstes Strahlenbündelfragment, das gemäß der Richtung Lo(Γ->L und Γ->ξ) eingespritzt wird, und ein zweites Fragment, das gemäß der Richtung ξ eingespritzt wird, aus einem Satz Richtungsvektoren L, W, Σ, ξ mit einer Versetzung von 4meV in Bezug auf den Wert des nicht dotierten Diamanten unterteilt wird.

13. Verfahren gemäß einem der Ansprüche 1 bis 10, **dadurch gekennzeichnet, dass**, wenn die Schicht des zu synthetisierenden Diamanten eine Dicke von mindestens 1 μm besitzt, der Diamant durch Einspritzen eines Borträgergases in die Kammer in einem Verhältnis von 0,01 bis 100 ppm in Bezug auf H2 dotiert wird und dass in das Plasma ein drittes Photonenstrahlenbündel mit einer Frequenz eingespritzt wird, die einer Interaktion Elektron-Photon entspricht, um eine Halbleitfähigkeit des Diamanten hervorzurufen.

14. Verfahren gemäß Anspruch 13, **dadurch gekennzeichnet, dass** das dritte Photonenstrahlenbündel in ein erstes Strahlenbündelfragment, das gemäß der Richtung L eingespritzt wird, und ein zweites Fragment, das gemäß der Richtung ξ des Richtungsvektorsatzes L, W, Σ, ξ eingespritzt wird, unterteilt wird.

15. Verfahren gemäß einem der Ansprüche 1 bis 10, **dadurch gekennzeichnet, dass**, wenn die Schicht des zu synthetisierenden Diamanten eine Dicke von wenigstens 1 μm besitzt, der Diamant durch Einspritzen eines Stickstoffträgergases in die Kammer mit einem Verhältnis von 0,1 zu 1 Stickstoff in Bezug auf das CH4 dotiert wird und dass in das Plasma ein viertes Photonenstrahlenbündel mit einer Frequenz eingespritzt wird, die einer Interaktion Elektron-Photon entspricht, die die Halbleitfähigkeit vom Typ n hervorruft.

16. Verfahren gemäß Anspruch 15, **dadurch gekennzeichnet, dass** das vierte Photonenstrahlenbündel in das Plasma gemäß dem Richtungsvektorsatz, das der Photonenfrequenz entspricht, die auf das Vorhandensein des Stickstoffs für das Zentrum vom Typ C zurückzuführen ist, und/oder gemäß drei Photonenstrahlenbündeln, die der Photonenfrequenz entsprechen, die auf das Vorhandensein des Stickstoffs für das Aggregat vom Typ A zurückzuführen ist, und/oder gemäß vier Photonenstrahlenbündeln, die der Photonenfrequenz entsprechen, die auf das Vorhandensein des Stickstoffs für das Aggregat vom Typ B zurückzuführen ist, eingespritzt wird.

17. Verfahren zum Bilden eines Halbleiters vom Typ Si-Ge per Gasphasenabscheidung, **dadurch gekennzeichnet, dass** das Abscheiden in einer Kammer durchgeführt wird, in der ein Plasma erzeugt wird, und dass es umfasst:

   - eine Silizium-Gasphasenabscheidung auf einem Substrat bei einer Temperatur zwischen 500 ° und 600 °C bei Vorhandensein von Wasserstoff und wobei die Kammer unter einem Druck zwischen 0,01 und 1.000 mbar gehalten wird, wobei das genannte Abscheiden durch Einspritzen eines Photonenstrahlenbündels, das der Frequenz des Phonons entspricht, die auf die auf die Verbindung Si-Si zurückzuführen ist, in die Kammer durchgeführt wird, bis die abgeschiedene Siliziumschicht eine Dicke von wenigstens 3 nm besitzt;
   - eine Stabilisierung der Temperatur des Substrats auf eine erste Temperatur zwischen 400° C und 550° C;
   - ein Germanium-Gasphasenabscheiden auf der Si-Schicht bei einer Temperatur zwischen 400 °C und 550 °C bis zum Erhalten einer Ge-Schicht von einer vorbestimmten Dicke mit Einspritzen eines Photonenstrahlenbündels, das der Frequenz des Phonons entspricht, das auf die Verbindung Si-Ge zurückzuführen ist, in die Kammer in einem ersten Schritt und in einem zweiten Schritt eines anderen Photonenstrahlenbündels, das der Frequenz des Phonons entspricht, das auf die Verbindung Ge-Ge zurückzuführen ist;
   - eine Inkrementierung der Temperatur des Gasphasenabscheidens auf einen Wert zwischen 750° C du 850° C bei Vorhandensein von Wasserstoff;
   - das Beibehalten des Einspritzens eines Photonenstrahlenbündels, der einer Frequenz des Phonons entspricht, das auf die Verbindung Ge-Ge zurückzuführen ist, bis zum Erhalt einer vorbestimmten Schichtdicke.

18. Verfahren gemäß Anspruch 17, **dadurch gekennzeichnet, dass** das Photonenstrahlenbündel gemäß einem Richtungsvektorensatz des Siliziums eingespritzt wird.

**19.** Vorrichtung zum Synthetisieren des Diamanten per Gasphasenabscheiden (CVD), wobei der zu synthetisierende Diamant eine Kristallographie mit einer Gruppe von möglichen Facetten umfasst, die mittels eines Richtungsvektorsatzes dargestellt ist oder jeder Vektor gibt eine normale Richtung zu einer bestimmten Seite des Diamanten an, wobei die genannte Vorrichtung umfasst

- eine Vakuumkammer (2), umfassend

\* einen Substratträger (3), der zum Tragen des zu synthetisierenden Diamanten angeordnet ist, und
\* einen Plasmagenerator, der zum Erzeugen eines Plasmas in der Kammer in der Nachbarkeit des Substratträgers angeordnet ist,
\* ein Bündelungssystem (9) des Plasmas, das zum Verbessern der Verteilung der Temperatur und des Plasmas in der Syntheseregion und der Abscheidung des Diamanten angeordnet ist,
\* einen Einführeingang eines Kohlenstoffträgergases in die Kammer, wobei die Kammer angeordnet ist, um dort ausgehend von dem Kohlenstoffträgergas und H2 ein Gas zu erzeugen, umfassend Radikale oder Moleküle in ungesättigter Form, aus dem die Synthese des Diamanten durchgeführt wird, wobei die genannte Vorrichtung umfasst,

- einen Generator 11-i eines Photonenstrahlenbündels (11-1 bis 5), insbesondere Infrarotstrahlen und/oder X-, UV- und sichtbare Strahlen, der auf der Kammer montiert ist, wobei das genannte Photonenstrahlenbündel Träger von bestimmten Energiemengen ist, die durch jede Frequenz bestimmt sind, die einer Absorptionsfrequenz entspricht, die in einem elektromagnetischen Absorptions- und unelastischem Verteilungsspektrum des zu synthetisierenden Diamanten entnommen ist, **dadurch gekennzeichnet, dass** der genannte Generator des Photonenstrahlenbündels auf die Kammer gerichtet derart montiert ist, dass das genannte erzeugte Strahlenbündel in die Kammer in das Plasma in einem Winkel eingespritzt ist, der sowohl den bestimmten Richtungsvektoren des Diamanten als auch dem Wellenvektor des Brillouin-Bereichs entspricht, der der Energie des Phononmodus unter Einschluss des Modus im Bereichszentrum zugeordnet ist und die in dem Photonenstrahlenbündel enthaltene Energie bestimmt.

**20.** Vorrichtung gemäß Anspruch 18 oder 19, **dadurch gekennzeichnet, dass** sie einen anderen Generator umfasst, der zum Erzeugen eines UV-c-Strahlenbündels angeordnet ist, wobei der genannte andere Generator auf der Kammer angeordnet ist, um ein Einspritzen der UV-c-Strahlen in das Plasma zu ermöglichen, das von dem genannten Plasmagenerator erzeugt ist.

**21.** Vorrichtung gemäß einem der Ansprüche 19 bis 20, **dadurch gekennzeichnet, dass** das Bündelungssystem (9) des Plasmas an der Peripherie des Substratträgers montiert ist.

**22.** Vorrichtung gemäß Anspruch 21, **dadurch gekennzeichnet, dass** das Bündelungssystem des Plasmas mittels eines Rings gebildet ist.

**23.** Vorrichtung gemäß Anspruch 21, **dadurch gekennzeichnet, dass** das Bündelungssystem des Plasmas mittels eines Drahts gebildet ist, der in Form einer Folge von Blockwellen um das Substrat angeordnet ist.

**Claims**

**1.** Method for synthesising diamond by chemical vapor deposition (CVD), in which a plasma is produce in a vacuum chamber in the vicinity of a substrate arranged to carry the diamond to be synthesised, and in which a carbon-carrying gas, in particular CH4 or C2H2, and H2 are introduced into the chamber in order to produce in the chamber a gas comprising substances containing reactive carbon atoms in the form of radicals or unsaturated molecules from which the synthesis of the diamond will be performed, **characterized in that** the electromagnetic absorption and inelastic division spectra of the diamond to be synthesised are used to take from the spectra the absorption frequencies which contribute to the reactions leading to the formation of the diamond to be synthesised and **in that** energetic rays are produced in the form of a beam of photons carrying amounts of energy determined by each of the frequencies corresponding to said absorption and inelastic diffusion frequencies, said beam of photons is injected into the plasma where, for energetic states of the diamond, an absorption of those photons having the energy corresponding to those energetic states is achieved by said gases carrying the reactive carbon atoms

**2.** Method according to claim 1 wherein infrared rays are used as energetic rays to achieve a coupling between the energetic states of the radicals or unsaturated molecules and the energetic states of the phonons of diamond.

3. Method according to claim 1, wherein X-rays, UV rays and visible rays are used as energetic rays.

4. Method according to one of claims 1 to 3, wherein the diamond to be synthesised comprises a crystallographic mesh which determines a set of facies and which is represented by two sets of directional vectors, the first one indicating the directions normal to the main reticular planes of highest atomic density determining the possible facies of the diamond, the second one consisting of the wave vectors allowed for the propagation of the phonon according to the crystallographic structure of the diamond, said beam of photons being oriented and injected according to directions indicated by two sets of directional vectors.

5. Method according to any of claims 1 to 4, wherein a UV-c beam is injected into the plasma.

6. Method according to any of claims 1 to 5, wherein the plasma is produced by the formation of an electric field in the vacuum chamber, said electric field being generated by a first and a second electric potential, said first electric potential is generated in a first zone offset in direction of the height from the substrate and the second electric potential is generated in a second zone located in the direct vicinity of the substrate, the first and the second zones being adjacent to each other, said first and second potentials having a gradient directed towards the substrate of which gradient rate of the first potential is higher than the one of the second potential.

7. Method according to claim 6, wherein the second potential is generated by using a generator located at the periphery of the substrate.

8. Method according to claim 6 or 7, wherein the first potential is generated by using a grid and a filament placed above the substrate.

9. Method according to any of claims 1 to 8, wherein the substrate is maintained at a predetermined temperature during the deposition of the diamond to be synthesised.

10. Method according to any of claims 1 to 9, wherein the deposition is achieved in the hot filament vapor phase.

11. Method according to any of claims 1 to 10, wherein when the diamond's layer to be synthesised has a thickness of at least 1 pm, the diamond is doped by injecting into the chamber a boron-carrier gas in a proportion of 0.01 to 200 ppm with respect to H2, and wherein a second beam of photons having a frequency corresponding to an electron-phonon interaction is injected into the plasma to cause superconductivity of the diamond

12. Method according to claim 11, wherein the second beam of photons is divided into a first beam fragment injected in the Lo direction (r-> L and r ->ç) and a second fragment injected in the Ç direction, of a set of directional vectors L, W, Z, Ç with an offset of 4 meV from the value of the non-doped diamond

13. Method according to one of the claims 1 to 10, wherein when the diamond's layer to be synthesised has a thickness of at least 1 pm the diamond is doped by injecting into the chamber a boron-carrier gas in a proportion of 0.01 to 100 ppm with respect to H2, and wherein a third beam of the photons having a frequency corresponding to an electron-phonon interaction is injected into the plasma to cause a semi-conductivity of the diamond.

14. Method according to claim 13, wherein the third beam of photons is divided into a first beam fragment injected in the L-direction and a second fragment injected in the Ç-direction of the set of L, W, Z, Ç.

15. Method according to one of the claims 1 to 10, wherein when the diamond's layer to be synthesised has a thickness of at least 1 pm, the diamond is doped by injecting into the chamber a nitrogen-carrying gas with a ratio of 0.1 to 1 of nitrogen from CH4, and wherein a fourth beam of the photons having a frequency corresponding to an electron-phonon interaction which causes the n-type semi-conductivity is injected into the plasma

16. Method according to claim 15, wherein the fourth beam of photons is injected into the plasma along the set of directional vectors corresponding to the phonon frequency due to the presence of nitrogen for the type C centre, and/or along three beams of photons corresponding to the phonon frequency due to the presence of nitrogen for the type A aggregate, and/or along four beams of photons corresponding to the phonon frequency due to the presence of nitrogen for the type B aggregate. of nitrogen for the type A aggregate, and/or along four beams of photons corresponding to the phonon frequency due to the presence of nitrogen for the type B aggregate.

17. Method for forming a semiconductor of type Si-Ge by chemical vapor deposition, **characterized by** the deposition is carried out in a chamber in which a plasma is produce and comprises:

- a chemical vapor deposition of Silicon on a substrate at a temperature of between 500° C and 600° C in the presence of hydrogen and having the chamber maintained at a pressure of between 0.01 and 1000 mbar, said deposition being carried out by injecting into the chamber a beam of photons corresponding to the frequency of the phonon due to the Si-Si bond until the deposited layer of Silicon has a thickness of at least 3nm;
- a stabilisation of the temperature of the substrate at a first temperature between 400° C and 550° C;
- a chemical vapor deposition of Germanium on the Si layer at a temperature between 400° C and 550° C until a Ge layer at a predetermined thickness is obtained with injection into the chamber firstly of a beam of photons corresponding to the frequency of the phonon due to the Si-Ge bond and secondly of another beam of photons corresponding to the frequency of the phonon due to the Ge-Ge bond;
- an increase of the temperature of the chemical vapor deposition to a value between 750°C and 850°C in the presence of hydrogen;
- maintaining the injection of a beam of photons corresponding to a frequency of the phonon due to the Ge-Ge bond until a predetermined thickness of layer is obtained.

18. Method according to claim 17, wherein the beam of photons is injected along a set of directional vectors of silicon.

19. Device for synthesising diamond by chemical vapor deposition (CVD), the diamond to be synthesised having a crystallography with a set of possible faces, represented by a set of directional vectors where each vector indicates a direction normal to a given face of the diamond, which device comprises:

- a vacuum chamber (2) comprising

* a substrate carrier (3) arranged to carry the diamond to be synthesised and
* a plasma generator arranged to produce a plasma in the chamber in the vicinity of the substrate carrier,
* a plasma focusing system (9) arranged to improve the temperature and plasma distribution in the synthesis and deposition region of the diamond,
* a carbon carrier gas inlet to the chamber, which chamber is arranged to produce therein from the carbon carrier gas and H2 a gas comprising radicals or molecules under unsaturated form from which diamond's synthesis will be carried out, which device comprises

- a generator 11-i of a beam of photons (11-1 to 5), in particular of infrared rays and/or X-rays, UV and visible rays, assembled on the chamber, said beam of photons carrying amounts of energy determined by each of the frequencies corresponding to an absorption frequency taken from an electromagnetic spectrum of absorption and inelastic diffusion of the diamond to be synthesized, characterized that said generator of beam of photons is mounted directionally on the chamber such that said generated beam is injected into the chamber, into the plasma, at an angle which corresponds to both the given directional vectors of the diamond and the wave vector of the Brillouin zone associated to the energy of the phonon mode including the mode at the zone centre, determining the energy contained in the beam of photons

20. Device according to claim 18 or 19, wherein it comprises a further generator arranged to produce a beam of UV-c radiation, which further generator is mounted on the chamber to allow injection of the UV-c radiation into the plasma generated by said plasma generator.

21. Device according to one of the claims 19 to 20, wherein the plasma focusing system (9) is mounted at the periphery of the substrate carrier.

22. Device according to claim 21, wherein the plasma focusing system is generated by a ring.

23. Device according to claim 21, wherein the plasma focusing system is generated by a wire disposed in a succession of block waves around the substrate.

**F i g . 1a**

*F i g . 1b*

11

11-1    11-(i+j)

2

Plasma

3

Substrat

# *Fig. 1c*

*Fig.2*

37

33

30

32

31

38

34

35

36

**Fig.3**

40

41

42

43

**Fig.4**

*Fig. 5*

61

60

3

**Fig.6**

62

3

**Fig.7**

63

3

**Fig.8**

*Fig.9*

*Fig.10*

*Fig. 11*

**Fig. 12**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4859490 A
- US 4898748 A
- US 5478608 A

**Littérature non-brevet citée dans la description**

- **JIE MA et al.** *Proceedings of the 13th International Symposium on Laser-aided Plasma Diagnostics,* 18 Septembre 2007, vol. 68, 206-211
- **POPOV C et al.** Thin Solid Films. Elsevier-Sequoia S.A, 26 Mai 2006, vol. 506-507, 297-302
- **J.E. BUTLER ; Y.A. MANKELEVICH ; A. CHEESMAN ; JIE MA ; M.N.R. ASHFOLD.** Understanding the chemical vapor déposition of diamond : récent progress. *Journal of Physics condensed Matter,* 2009, vol. 21
- **CLAUDE KLEIN ; THOMAS HARTNETT ; CIIFFORD ROBINSON.** Critical-point phonon frequencies of diamond. *Physica! Review B,* 01 Juin 1992, vol. 45 (22
- **R. VOGELGESANG ; A. ALVARENGA ; HYUN-JUNG KIM ; A. RAMDAS ; S. RODRIGUES.** Multiphonon Raman and infrared spectra of isotopically controlled diamond. *Physical Review B,* Septembre 1998, vol. 58 (9), 5408-5416
- **A. RAMDAS.** Raman, Brillouin and infrared spectroscopy of phonons in conventional diamond. *IEE,* Juillet 2000
- **M. HOESCH.** Discovery of phonons causing superconductivity in diamonds looking for room température - superconductors in diamonds. *JAEA R&D,* 2007, 45